# EUROPEAN PATENT APPLICATION

(11) **EP 4 447 631 A2**
(43) Date of publication of application: **16.10.2024**
(21) Application number: 24168279.8
(22) Date of filing: 03.04.2024
(51) Int. Cl.: H05K 7/20

(54) **MODULAR AIR HANDLING UNIT (AHU) SYSTEM**

(30) Priority: 12.04.2023 US 202363458807 P; 14.03.2024 US 202418605222
(71) Applicant: Vertiv Corporation, Westerville, OH 43082 (US)
(72) Inventor: RANCIC, Denis, ZAGREB (HR); MERKAS , Antonio, ZAGREB (HR); KUSEN, Vanja, ZAGREB (HR); PAJIC, Marin, ZAGREB (HR)
(74) Representative: Algemeen Octrooi- en Merkenbureau B.V.

(57) **Abstract**

The invention relates to a modular air handling unit (AHU) system including a set of cooling unit building blocks and a housing configured to house the set of cooling unit building blocks. The housing includes an air supply corridor configured to receive fresh air and an air return corridor configured to receive used air and distribute the received used throughout the set of cooling unit building blocks. Each cooling unit building block of the set of cooling unit building blocks includes an exchangeable air-conditioning (AC) section positioned proximate to the air supply corridor. The exchangeable AC section include an exchangeable AC assembly removably coupled to the exchangeable AC section. The exchangeable AC section include an array of supply fans configured to distribute the fresh air from the air supply corridor to the exchangeable AC assembly.

## Description

### TECHNICAL FIELD

The present disclosure generally relates to the field of air handling units, and more particularly to a modular air handling unit (AHU) system for modular data centers.

### BACKGROUND

Controlling the temperature inside a data center is important to prevent damage or disruption to equipment within the data center and ensure that the data center equipment runs efficiently and safely. Data center cooling units are used to control such temperature within the data center.

Modular data centers are often portable enclosures (or buildings) used to house data center infrastructure, information technology (IT) equipment, and power equipment and used to deploy data center capacity wherever capacity is needed. Conventional cooling units are not optimal for such modular data centers. For example, the conventional cooling units have higher power consumption (i.e., higher power usage effectiveness factor (PUE)), inefficient space utilization, and high design and site planning efforts which are dependent on the desired cooling technology.

As such, it would be advantageous to provide a system or apparatus to remedy the shortcomings of the conventional approaches identified above.

### SUMMARY

According to a first aspect of the present invention relates to an air handling unit system is disclosed, in accordance with one or more embodiments of the present disclosure. The air handling unit system includes a set of cooling unit building blocks. The air handling unit system includes a housing configured to house the set of cooling unit building blocks, the housing at least partially formed of a plurality of sidewalls and one or more framing members. The housing includes an air supply corridor configured to receive fresh air, the air supply corridor positioned proximate to at least one sidewall of the plurality of sidewalls. The housing includes an air return corridor, the air return corridor including one or more vent walls, the air return corridor configured to receive used air and distribute the received used throughout the set of cooling unit building blocks. Each cooling unit building block of the set of cooling unit building blocks includes an exchangeable air-conditioning (AC) section positioned proximate to the air supply corridor, the exchangeable AC section including an exchangeable AC assembly removably coupled to the exchangeable AC section, the exchangeable AC section including an array of supply fans, the array of supply fans configured to distribute the fresh air from the air supply corridor to the exchangeable AC assembly.

According to another aspect, the invention relates to an air handling unit system. The air handling system includes a set of cooling unit building blocks. The air handling system includes a housing configured to house the set of cooling unit building blocks, the housing at least partially formed of a plurality of sidewalls and one or more framing members. The housing includes an air supply corridor configured to receive fresh air, the air supply corridor positioned proximate to at least one sidewall of the plurality of sidewalls. The housing includes an air return corridor, the air return corridor including one or more vent walls, the air return corridor configured to receive used air from one or more data centers positioned proximate to a front sidewall of the plurality of sidewalls and distribute the received used throughout the set of cooling unit building blocks. Each cooling unit building block of the set of cooling unit building blocks includes an exchangeable air-conditioning (AC) section positioned proximate to the air supply corridor, the exchangeable AC section including an exchangeable AC assembly removably coupled to the exchangeable AC section, the exchangeable AC section including an array of supply fans. In embodiments, the array of supply fans is configured to distribute the fresh air from the air supply corridor to the one or more data centers and drive the fresh air through the one or more data centers. In embodiments, a cooling technology of the exchangeable AC assembly is configured to be switched out and thereby exchanged for an additional cooling technology.

According to a third aspect of the invention is related to a method. The method includes receiving used air from one or more data centers through an air return corridor via one or more vents wall of an air handling unit system, where the one or more data centers are positioned proximate to the air handling unit system. The method includes providing the used air to a set of cooling unit building blocks including an exchangeable air-conditioning (AC) section to generate fresh air using an exchangeable AC assembly of the exchangeable AC section. The method includes providing the fresh air generated by the exchangeable AC assembly to the one or more data centers through an air supply corridor via an array of supply fans.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1A is a cross-section side view of a modular air handling unit (AHU) system, in accordance with the present invention.
FIG. 1B is a front perspective view of the modular AHU system, in accordance with the present invention.
FIG. 1C is a front perspective view of the modular AHU system, in accordance with the present invention.
FIG. 1D is a rear perspective view of the modular AHU system, in accordance with the present invention.
FIG. 1E is a perspective view of the modular AHU system, in accordance with the present invention.
FIG. 2 is a flow chart depicting a method for cooling using the modular AHU system, in accordance with the present invention.

### DETAILED DESCRIPTION

Reference will now be made in detail to the subject matter disclosed, which is illustrated in the accompanying drawings.

Controlling the temperature inside a data center is important to prevent damage or disruption to equipment within the data center and ensure that the data center equipment runs efficiently and safely. Data center cooling units are used to control such temperature within the data center.

Modular data centers are often portable enclosures (or buildings) (e.g., transportable units or subcomponents) used to house data center infrastructure, information technology (IT) equipment, and power equipment and used to deploy data center capacity wherever capacity is needed. Conventional cooling units are not optimal for such modular data centers. For example, the conventional cooling units have higher power consumption (i.e., higher power usage effectiveness factor (PUE)), inefficient space utilization, and high design and site planning efforts which are dependent on the desired cooling technology.

Accordingly, the present invention is directed to a modular air handling unit (AHU) system. More particularly, the present invention is directed to a modular AHU system for a modular data center (e.g., a prefabricated modular data center). Specifically, the present invention is directed to a modular AHU system including a set of cooling unit building blocks, where each cooling unit building block is fitted next to each other and completely independent of each other to enable redundancy within the modular AHU system. Further, the present invention is directed to a modular AHU system including an exchangeable air-conditioning (AC) section, where an exchangeable AC assembly of the section may be switched out to adjust the functionality of the modular AHU system. In this regard, the cooling technology of the modular AHU system may be modified to meet the needs of any of a variety of data centers.

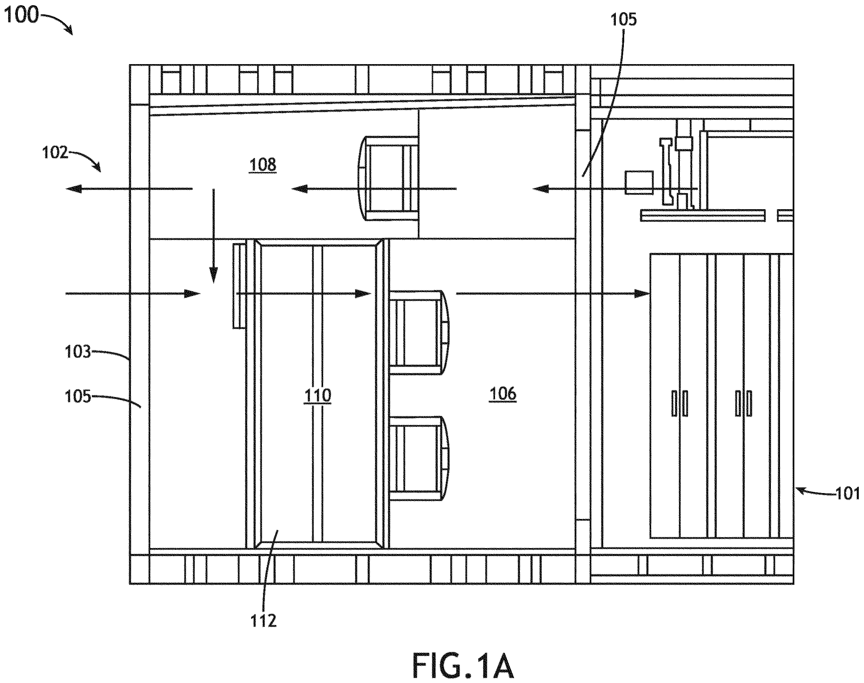

Referring to FIGS. 1A-1E, a modular AHU system 100 of the present invention is shown.

The modular AHU system 100 includes a housing 102 configured to house one or more components of the AHU system 100. For example, the housing 102 may be configured to provide structural integrity and support for the one or more components of the AHU system 100. In this regard, the housing 102 may be configured to minimize air leakage.

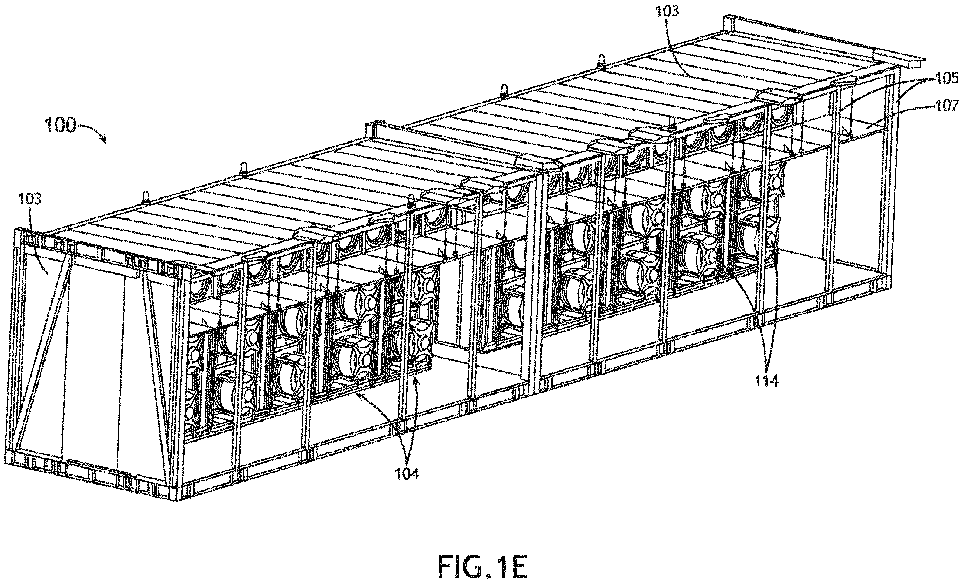

The housing 102 is formed of one or more sidewalls 103 and one or more framing members 105. For example, the housing 102 may include a first sidewall 103 (e.g., rear sidewall 103), a second sidewall 103 (e.g., a front sidewall 103), a third sidewall 103 (e.g., left-side sidewall 103), fourth sidewall 103 (e.g., right-side sidewall 103), and a fifth sidewall 103 (e.g., top sidewall 103). Further, as shown in FIG. 1E, the housing 102 may include one or more vertical framing members on the front sidewall. It is contemplated herein that although FIG. 1E depicts the housing 102 including a specific number and configuration of framing members 105, the housing 102 may include any number and configuration of framing members 105. Additionally, FIG. 1E depicts the front sidewall being completely exposed, it is contemplated herein that the front sidewall may be partially exposed while still being able to distribute cool air to a data center positioned proximate to the front sidewall of the AHU system 100. As mentioned earlier, it is contemplated that appropriate sealing (e.g., gaskets, seals, etc.) may be employed at the respective junctions between the various sidewalls 103 to minimize cooling losses.

It is noted that the housing 102 or one or more components thereof may be formed of any rigid material suitable for supporting the cooling equipment. For example, one or more components of the housing 102 may be formed of one or more metals.

The housing 102 includes one or more airflow corridors (or sections). The airflow corridors includes one or more supply airflow corridors 106 (e.g., an air supply plenum section). For example, the housing 102 of the modular AHU system 100 may include a supply airflow corridor 106 arranged on a front side of the AHU system 100 (proximate to the front sidewall 103). For instance, the frontal supply airflow corridor 106 may be configured to distribute cool air to a data center positioned proximate (e.g., proximate to the front sidewall 103) to the modular AHU system 100, such as the data center 101 shown in FIG. 1A.

The one or more airflow corridors further includes one or more return airflow corridors 108 (e.g., an air return plenum section). For example, the housing 102 of the modular AHU system 100 may include a return airflow corridor 108 arranged on a top side of the AHU system 100. For instance, a top portion of the housing 102 may include the return airflow corridor 108, where the return airflow corridor 108 may be defined by an internal sidewall 107 and the top sidewall 103. The airflow corridors 108, like the housing 102, may also incorporate sealing to minimize airflow/cooling losses.

In some embodiments, the one or more return airflow corridors 108 may include one or more return filters.

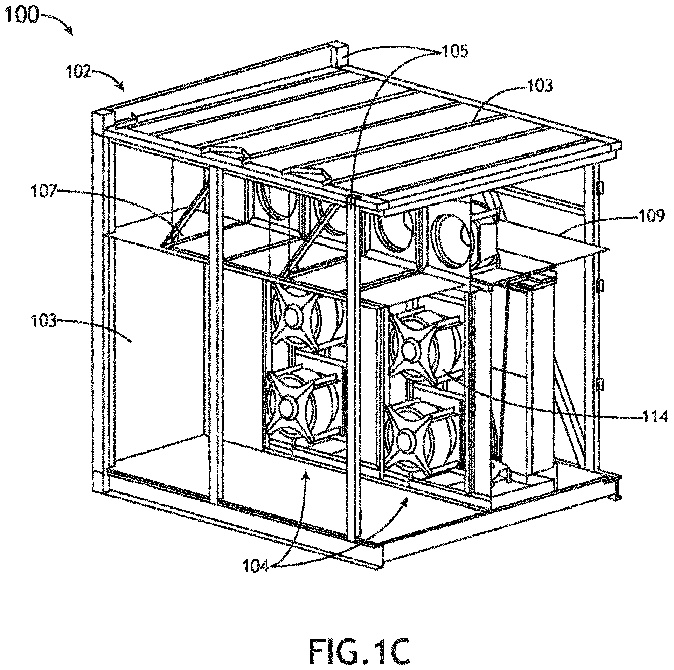

Referring to FIG. 1C, the return airflow corridor 108 includes one or more vent walls 109. The one or more vent walls 109 may include at least one of one or more inlet louvres, one or more mixing louvres, or one or more exhaust louvres. For example, as shown in FIG. 1A, used air from the data center 101 may enter the return airflow corridor 108 via the one or more vent walls 109 and enter the exchangeable AC section 110 to be cooled again.

In some embodiments, the one or more inlet louvres and/or the one or more exhaust louvres may be arranged on a sidewall 103, where the one or more mixing louvres may be arranged on the internal sidewall/separator 107.

In some embodiments, the one or more inlet louvres and/or the one or more exhaust louvres may be arranged on an external component coupled to the AHU system 100. For example, the external component may be coupled to the AHU system 100 and arranged adjacent to the AHU system 100 (e.g., on the left side), where the external component may act as an external addendum to support the one or more vent walls 109.

In some embodiments, the return airflow corridor 108 may further include a return fan configured to push the air from the data center 101. For example, the return fan may be configured to push air from the data center 101 to be expelled through an exhaust louvre. By way of another example, the return fan may be configured to push used air from the data center 101 to be returned to the AHU system 100 for re-cooling through the mixing louvre.

The modular AHU system 100 further includes a set of cooling unit building blocks 104. For example, the set of cooling unit building blocks 104 is housed within the housing 102, as shown in FIG. 1E.

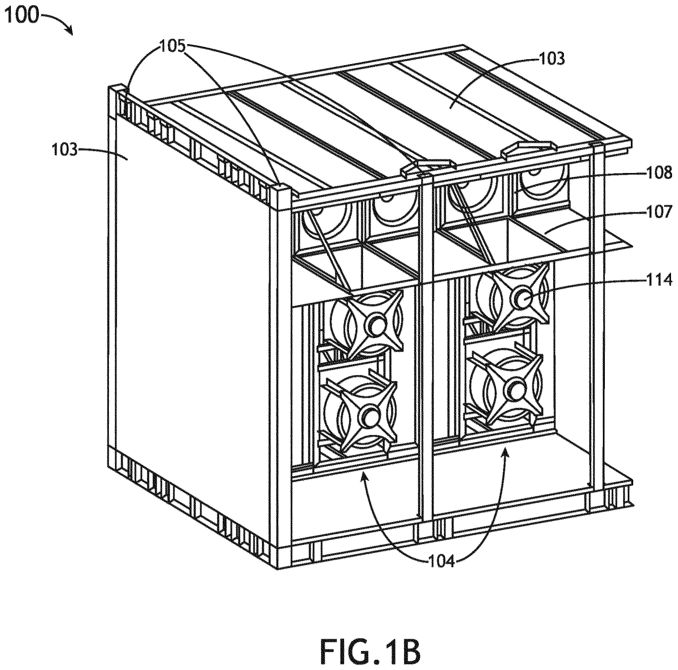

A respective cooling unit building block of the set of cooling unit building blocks 104 may be fixed next to an additional cooling unit building block. For example, as shown in FIGS. 1B-1C, the modular AHU system 100 may include a set of cooling unit building blocks 104. For instance, as shown in FIGS. 1B-1C, the set of cooling unit building blocks 104 may include a first unit and a second unit, where the first unit may be positioned adjacent to the second unit. It is noted that the set of cooling unit building blocks 104 may be completely independent of each other (e.g., operate independently), thus enabling redundancy within the AHU system 100.

The modular AHU system 100 further includes an exchangeable air-conditioning (AC) section 110. For example, each cooling unit building block 104 may include an exchangeable AC section 110.

The exchangeable AC section 110 includes an exchangeable AC assembly 112 removably (or reversibly) coupled to the AHU system 100 such that the exchangeable AC assembly 112 may be exchanged to adjust the functionality of the modular AHU system 100. As such, the cooling technology of the exchangeable AC assembly 112 may be done for multiple reasons (e.g., service/maintenance, customer request, or the like). For example, the exchangeable AC assembly 112 may be exchanged to switch out a direct expansion (DX) cooling coil with a cold water (CW) cooling coil and associated auxiliary components to adjust the functionality of the AHU system 100. In a non-limiting example, a customer may ask on Day 1 for 100% freecooling and go on to ask for 50% CW cooling on day 2. Alternatively, in a non-limiting example, a customer may ask for 100% air-cooled on Day 1, and 70% liquid cooled on day 2.

The exchange of the cooling technology of the exchangeable AC assembly 112 may be done through the service corridor 116.

The exchangeable AC assembly 112 may include any suitable cooling technology including, but not limited to, direct expansion cooling, chilled water-cooling, direct evaporative cooling (e.g., adiabatic pad cooling), free cooling, or the like, or a combination thereof.

The exchangeable AC section 110 further includes a fan assembly 114 including an array of supply fans 114. For example, the array of supply fans 114 is configured to supply fresh air to the data center 101 and drive air flow through the data center 101. It is noted that the supply fans 114 may be adapted to the cooling solution pressure drop and air needs.

Although FIGS. 1B-1C depict a specific configuration of supply fans 114 (e.g., number, arrangement, and the like), it is noted that the exchangeable AC section 110 may include any configuration of supply fans 114 suitable for cooling a data center.

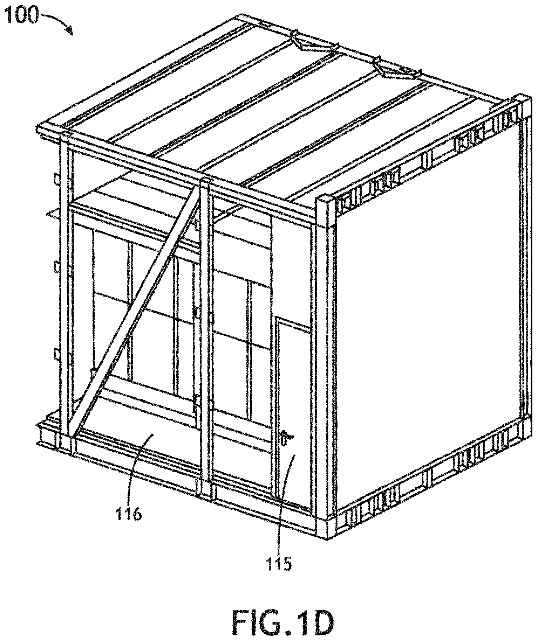

The modular AHU system 100 may further include one or more service corridors 116. For example, as shown in FIG. 1D, the AHU system 100 may include a service corridor 116 positioned below the return corridor 108 and arranged proximate to the exchangeable AC section 110. It is noted that the one or more service corridors 116 may be arranged in any location suitable for servicing one or more components of the AHU system 100 and performing the cooling technology exchange of the exchangeable AC assembly 112.

Referring to FIG. 1D, the modular AHU system 100 may include one or more doors 115 for accessing the one or more service corridors 116.

FIGS. 1A-1E are provided merely for illustrative purposes and shall not be construed as limiting the scope of the present invention. It is noted that the modular AHU system 100 may include any number, shape, size, or configuration of cool unit blocks, air flow corridors, and/or exchangeable AC sections.

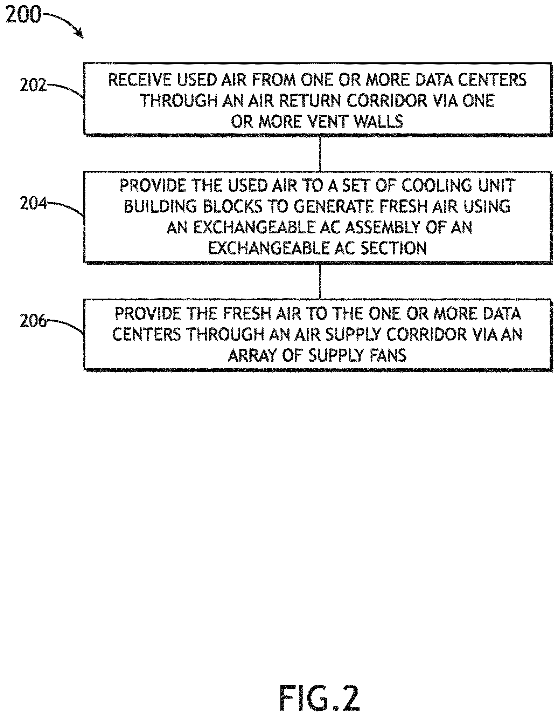

FIG. 2 is a flowchart of method 200 for cooling using the modular AHU system 100, in accordance with one or more embodiments of the present invention. In a step 202, used air from one or more data centers may be received through an air return corridor via one or more vents wall of an air handling unit system, wherein the one or more data centers are positioned proximate to the air handling unit system.

In a step 202, used air from the data center 101 may enter the return corridor 108 via the one or more vent walls 109.

In a step 204, the used air may enter the exchangeable AC section 110, where the exchangeable AC assembly 112 of the exchangeable AC section 110 receives the air and cools such air.

In a step 206, the array of supply fans 114 may push the cooled air from the exchangeable AC section 110 out through the air supply plenum section 106 to the data center 101.

It is contemplated that each of the embodiments of the method described above may include any other step(s) of any other method(s) described herein. In addition, each of the embodiments of the method described above may be performed by any of the systems described herein.

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). For example, the electrical circuitry may be used to facilitate the controlled operation of the cooling system associated with a given modular AHU system 100. Those having skill in the art will recognize that the subject matter described herein may be implemented in an analog or digital fashion or some combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter defined in the appended claims.. Furthermore, it is to be understood that the invention is defined by the appended claims.

## Claims

1. An air handling unit system (100), the air handling unit system (100) comprising:
a set of cooling unit building blocks (104);
a housing (102) configured to house the set of cooling unit building blocks (104), the housing (102) at least partially formed of a plurality of sidewalls (103) and one or more framing members (105), the housing (102) comprising:
an air supply corridor (106) configured to receive fresh air, the air supply corridor (106) positioned proximate to at least one sidewall (103) of the plurality of sidewalls; and
an air return corridor (108), the air return corridor (108) including one or more vent walls (109), the air return corridor (108) configured to receive used air and distribute the received used air throughout the set of cooling unit building blocks (104); and
each cooling unit building block (104) of the set of cooling unit building blocks comprising:
an exchangeable air-conditioning (AC) section (110) positioned proximate to the air supply corridor (106), the exchangeable AC section (110) including an exchangeable AC assembly (112) removably coupled to the exchangeable AC section (110), the exchangeable AC section including an array of supply fans (114), the array of supply fans (114) configured to distribute the fresh air from the air supply corridor (106) to the exchangeable AC assembly (112).

2. An air handling unit system (100), the air handling system (100) comprising:
a set of cooling unit building blocks (104);
a housing (102) configured to house the set of cooling unit building blocks (104), the housing at least partially formed of a plurality of sidewalls (103) and one or more framing members (105), the housing (102) comprising:
an air supply corridor (106) configured to receive fresh air, the air supply corridor (106) positioned proximate to at least one sidewall (103) of the plurality of sidewalls; and
an air return corridor (108), the air return corridor (108) including one or more vent walls (109), the air return corridor configured to receive used air from one or more data centers (101) positioned proximate to a front sidewall (103) of the plurality of sidewalls and distribute the received used throughout the set of cooling unit building blocks (104); and
each cooling unit building block (104) of the set of cooling unit building blocks comprising:
an exchangeable air-conditioning (AC) section (110) positioned proximate to the air supply corridor (106), the exchangeable AC section (110) including an exchangeable AC assembly (112) removably coupled to the exchangeable AC section (110), the exchangeable AC section (110) including an array of supply fans (114), the array of supply fans (114) configured to distribute the fresh air from the air supply corridor (106) to the one or more data centers (101) and drive the fresh
air through the one or more data centers (101),
wherein a cooling technology of the exchangeable AC assembly (112) is configured to be switched out and thereby exchanged for an additional cooling technology.

3. The air handling unit system (100) of Claim 1, wherein the exchangeable AC assembly (112) comprises at least one of:
a direct expansion cooling assembly, a chilled water-cooling assembly, a direct evaporation cooling assembly, or an air free cooling assembly.

4. The air handling unit system (100) of Claim 1 or 2, wherein the air supply corridor (106) is positioned proximate to a front sidewall (103) of the plurality of sidewalls.

5. The air handling unit system (100) of Claim 1 or 2, wherein the air return corridor (108) is positioned in a top portion of the housing (102).

6. The air handling unit system (100) of Claim 5, wherein the air return corridor (108) is defined at least partially by a top sidewall (103) of the plurality of sidewalls and an internal sidewall (103) of the plurality of sidewalls.

7. The air handling unit system (100) of Claim 1 or 2, further comprising:
one or more service corridors (116).

8. The air handling unit system (100) of Claim 1 or 2, wherein the air return corridor (108) further comprises:
one or more return fans, wherein the air return corridor (108) is configured to receive used air through the one or more return fans.

9. The air handling unit system (100) of Claim 1 or 2, wherein the one or more vent walls (109) include at least one of:
one or more inlet louvres, one or more mixing louvres, or one or more exhaust louvres.

10. The air handling unit system (100) of Claim 2, wherein at least one of the cooling technology or the additional cooling technology of the exchangeable AC assembly (112) comprises at least one of:
a direct expansion cooling assembly, a chilled water-cooling assembly, a direct evaporation cooling assembly, or an air free cooling assembly.

11. The air handling unit system (100) of Claim 10, wherein the direct expansion cooling assembly of the exchangeable AC assembly (112) is exchanged with a chilled water-cooling assembly.

12. A method (200) comprising:
receiving used air from one or more data centers (101) through an air return corridor (108) via one or more vents wall (109) of an air handling unit system (100), wherein the one or more data centers (101) are positioned proximate to the air handling unit system (100);
providing the used air to a set of cooling unit building blocks (104) including an exchangeable air-conditioning (AC) section (110) to generate fresh air using an exchangeable AC assembly (112) of the exchangeable AC section (110); and
providing the fresh air generated by the exchangeable AC assembly (112) to the one or more data centers (101) through an air supply corridor (106) via an array of supply fans (114).

13. The method (200) of Claim 12, further comprising:
exchanging a cooling technology of the exchangeable AC assembly (112) of the exchangeable AC section (110) to adjust a functionality of the air handling unit system (100).

14. The method (200) of claim 13, wherein the cooling technology of the exchangeable AC assembly (112) comprises at least one of:
a direct expansion cooling assembly, a chilled water-cooling assembly, a direct evaporation cooling assembly, or an air free cooling assembly.

15. The method (200) of claim 12, wherein the air handling system is the air handling unit system (100) of any of claims 1-11.
